Europäisches Patentamt

European Patent Office

Office européen des brevets

(11) Veröffentlichungsnummer: **0 292 807**
**A2**

(12) **EUROPÄISCHE PATENTANMELDUNG**

(21) Anmeldenummer: **88107680.6**

(22) Anmeldetag: **13.05.88**

(51) Int. Cl.⁴: **B65G 49/06**

(30) Priorität: **26.05.87 DE 3717628**

(43) Veröffentlichungstag der Anmeldung:
**30.11.88 Patentblatt 88/48**

(84) Benannte Vertragsstaaten:
**AT BE CH FR GB IT LI LU NL SE**

(71) Anmelder: **Löhr & Herrmann GmbH**
**Hesselbachstrasse 15**
**D-7531 Neuhausen(DE)**

(72) Erfinder: **Löhr, Hans-Günter, Dr.-Ing.**
**Hindenburgstrasse 21**
**D-7260 Calw(DE)**
Erfinder: **Herrmann, Gunter, Dr.-Ing.**
**Ahornweg 3**
**D-7135 Wiernsheim(DE)**
Erfinder: **Mozzi, Josef W.**
**Marienweg 3**
**D-7141 Schwieberdingen(DE)**

(74) Vertreter: **Hubbuch, Helmut, Dipl.-Ing et al**
**Westliche 29-31 Am Leopoldplatz**
**D-7530 Pforzheim(DE)**

(54) **Vorrichtung zum Ein- und Ausgeben von Leiterplatten in geschlitzte Wechselpaletten.**

(57) Die Erfindung betrifft eine Vorrichtung zum Ein-
und Ausgeben von Leiterplatten in geschlitzte Wechselpaletten, in welchen die Leiterplatten frei und in
aufrechter Lage speicherbar sind, wobei die einzelnen Leiterplatten in waagrechter Lage auf Rollenbahnen in schwenkbar angeordnete Greifer einlaufen,
hierbei vorzugsweise am vorderen Plattenrand
klemm- und näherungsweise in die Senkrechte über
entsprechende Schlitze an einer unterhalb des Greifers positionierten Wechselpalette bringbar
sind,wonach die Greifer beim Weiterführen vom aufgestellten Plattenrand ausschwenk-und rückbringbar
sind.

Fig.2

## Vorrichtung zum Ein- und Ausgeben von Leiterplatten in geschlitzte Wechselpaletten

Die Erfindung bezieht sich auf eine Vorrichtung zum Ein- und Ausgeben von Leiterplatten in geschlitzte Wechselpaletten, in welchen die Leiterplatten berührungsfrei und in aufrechter Lage speicherbar sind.

Es ist bekannt, Leiterplatten mit Staplern horizontal oder vertikal ein- oder auszugeben, wobei die Leiterplatten aber stets auf- oder aneinanderliegend gespeichert werden. Ferner ist es bekannt, Leiterplatten in Fördereinrichtungen mit einzelnen Taschen ein- und auszugeben, wobei in den Taschen jeweils nur einer Leiterplatte transportierbar ist. Diese Einrichtungen arbeiten nach dem Zwangsdurchlaufprinzpi, d.h. mit jedem Takt wird eine Leiterplatte eingegeben und auf der gegenüberliegenden Seite wiederum eine ausgegeben. Hierbei sind die Taschen fest mit der Einrichtung verbunden und erfordern einen hohen Platzbedarf.

Schließlich werden geschlitzte Wechselpaletten in Form sogen. "Schlitzbretter" verwendet, in welche die Leiterplatten von Hand einzustecken sind. Die Schlitze sind in entsprechenden Abständen in den Schlitzbrettern angebracht, so daß sich die Leiterplatten gegenseitig nicht berühren. Diese Voraussetzung ist in der Fertigung von Leiterplatten zumindestens an den Stellen zu erfüllen, an welchen die Oberflächen der Leiterplatten empfindlich gegen Berühren sind, z.B. nach dem Abziehen der Schutzfolie von belichteten Leiterplatten.

Der Erfindung liegt nun die Aufgabe zu Grunde, eine Vorrichtung zu schaffen, mit welcher Leiterplatten automatisch in geschlitzte Wechselpaletten eingegeben oder daraus entnommen werden können, in denen die Leiterplatten ohne sich gegenseitig zu berühren, in näherungsweise senkrechter Lage zu speichern sind und die einfach wechselbar sind.

Diese Aufgabe wird bei der Vorrichtung nach dem Oberbegriff von Anspruch 1 erfindungsgemäß dadurch gelöst, daß die einzelnen Leiterplatten in waagrechter Lage auf Rollenbahnen in schwenkbar angeordnete Greifer einlaufen, hierbei vorzugsweise am vorderen Plattenrand klemm- und näherungsweise in die Senkrechte über entsprechende Schlitze an einer unterhalb des Greifers positionierten Wechselpalette bringbar sind, wonach die Greifer beim Weiterführen vom aufgestellten Plattenrand ausschwenk- oder rückbringbar sind. Hierbei - schwenken die Greifer um ein kurzes Stück unter das Niveau der Schlitze weiter, so daß die Greifer aus dem Leiterplattenbereich herauskommen und dieselben in den Schlitzen der Wechselpaletten stecken bleiben. Die Tatsache, daß die Greifer bei diesem Vorgang am Rande der Leiterplatten gleiten, ist unschädlich, da stets ein freier Randstreifen an der Leiterplatte vorhanden ist, in dessen Bereich der Greifer die Leiterplatte festhält.

Damit die Leiterplatten sicher in den Greifer einlaufen können und während der Schwenkbewegung festgehalten werden, ist dieser mit mehreren festen und beweglichen Klemmbacken ausgeführt, die über der gesamten Breite der Vorrichtung angeordnet sind. Der Antrieb der beweglichen Klemmbacken erfolgt gemeinsam mittels eines Pneumatikzylinders, der am Schwenkarm des Greifers befestigt ist. Damit wird erreicht, daß die Leiterplatten an beliebiger Stelle, einfach oder mehrfach nebeneinander, in die Vorrichtung einlaufen und ohne vorhergehendes Ausrichten in die Palette eingegeben werden können.

Damit ferner die Klemmbacken des Greifers unter das Schlitzniveau geschwenkt werden können, bestehen die Paletten aus einer Grundplatte mit mehreren daraufbefestigten eingeschlitzten Leisten. Zwischen den Leisten besteht ein Zwischenraum, in den die Klemmbacken eintauchen können. Die Schlitze verlaufen in der Tiefe nur etwa bis zur Hälfte der Dicke der Leisten, so daß die Klemmbacken unter das Aufstellniveau der Leiterplatten geschwenkt werden können. Nachdem der Greifer in seine untere Stellung geschwenkt ist, wird die Palette um einen Schlitzabstand weitergetaktet, so daß anschließend der Greifer wieder in seiner obere Stellung zurückgeschwenkt werden kann, ohne die zuvor abgestellte Leiterplatte mitzunehmen.

Damit schließlich der Vorschub genau ausgeführt wird, ist die Wechselpalette auf einem Palettentisch aufge setzt, welcher Teil der Vorrichtung ist, und dort in einer genauen Position mit Anschlägen bzw. Klinken fixiert wird. Der Palettentisch ist in Förderrichtung in Längsführungen geführt. An seiner Unterseite ist ein Mitnehmer mit genauer Teilung angebracht, in den eine Klinke eingreift, die den Vorschub bewirkt. Die Klinke ist an der Vorrichtung angebracht und wird mit zwei Pneumatikzylindern angetrieben.

Wenn die Palette um einen Schlitzabstand weitergetaktet ist, wird sie in der erreichten Stellung festgeklemmt. Hierzu ist eine Klemmvorrichtung vorhanden, die in eine am Palettenwagen angebrachte Klemmschiebe eingreift. Sie wird gespannt, wenn der Vorschub des Palettenwagens beendet ist, entspannt vor Beginn des nächsten Taktes. Nachdem die Palette gefüllt ist, wird der Vorschub abgeschaltet. Die gefüllte Palette mitsamt dem Palettenwagen wird dann von Hand zuerst in Förderrichtung an einen Anschlag geschoben, die Paletten entriegelt und dann quer zu Transportrichtung z.B. auf einen fahrbaren Transporttisch geschoben.

Wird die Vorrichtung zum Eingeben von Leiterplatten verwendet, läuft der beschriebene Ablauf in umgekehrter Reihenfolge ab. Bei Verwendung der Vorrichtung nur zum Eingeben der Leiterplatten von der Palette in eine Maschine braucht der Greifer nur mit starren Mitnehmern anstelle der festen und beweglichen Klemmbacken ausgerüstet werden.

Eine bevorzugte Ausführungsform einer Vorrichtung gemäß der Erfindung ist beispielsweise in der Zeichnung dargestellt und zwar zeigen in - schematischer Darstellung:

Fig. 1 eine Draufsicht der gesamten Vorrichtung,

Fig. 2 eine Seitenansicht der Vorrichtung,

Fig. 3 und 4 den Schwenkgreifer beim Einlaufen und Festklemmen einer Leiterplatte,

Fig. 5 die Leiterplatten beim Einstellen in die Schlitze der Wechselpalette,

Fig. 6 den fahrbaren Palettentisch mit aufgesetzter Palette,

Fig. 7 die Funktion des taktweisen Vorschubs des Palettentisches,

Fig. 8 die Klemmvorrichtung mit welcher der Palettentisch fixiert wird,

Fig. 9 eine Ausführung des Greifers, wenn die Vorrichtung zum Eingeben von Leiterplatten aus einer Palette in eine Maschine verwendet wird.

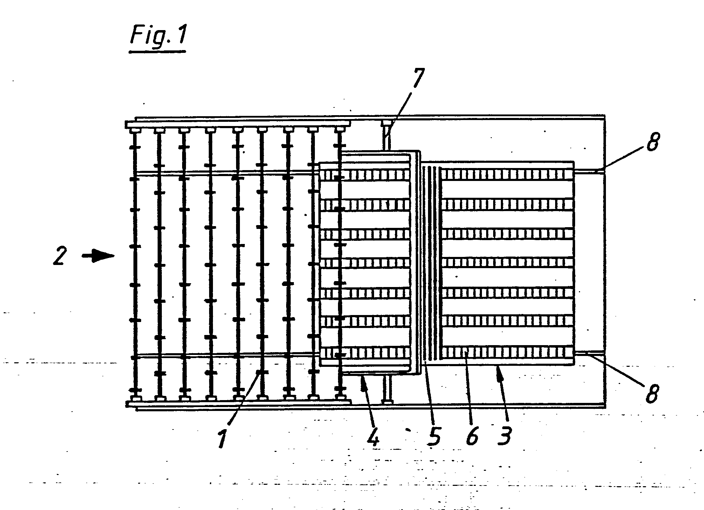

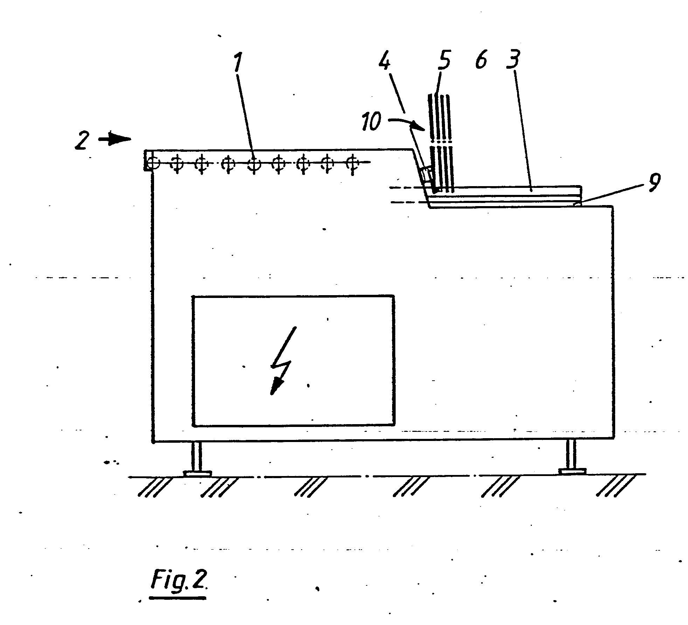

In der Draufsicht der gesamten Vorrichtung nach Fig.1 ist ein Waagrechtförderer gezeigt, welcher aus einem Feld aus synchron angetriebener Walzen 1 mit waagrechter Drehachse gebildet ist. Die Förderrichtung ist durch den Pfeil 2 gekennzeichnet und gilt für den Fall, daß die Vorrichtung zum Ausgeben von Leiterplatten aus einer davorstehenden Maschine in die Palette 3 benutzt wird. Der Greifer 4 ist in der Stellung gezeigt, in welcher er die Leiterplatte 5 in die Schlitze der geschlitzten Leisten 6 eingibt. Quer zur Förderrichtung ist die Schwenkachse 7 des Greifers, in Förderrichtung sind die Führungen 8 des unterhalb der Palette liegenden Palettentisches angeordnet. Die Seitenansicht der gesamten Vorrichtung nach Fig. 2 zeigt den Palettentisch 9 und, mit Pfeil 10, die Schwenkrichtung des Greifers beim Einsetzen der Leiterplatte in die Wechselpalette.

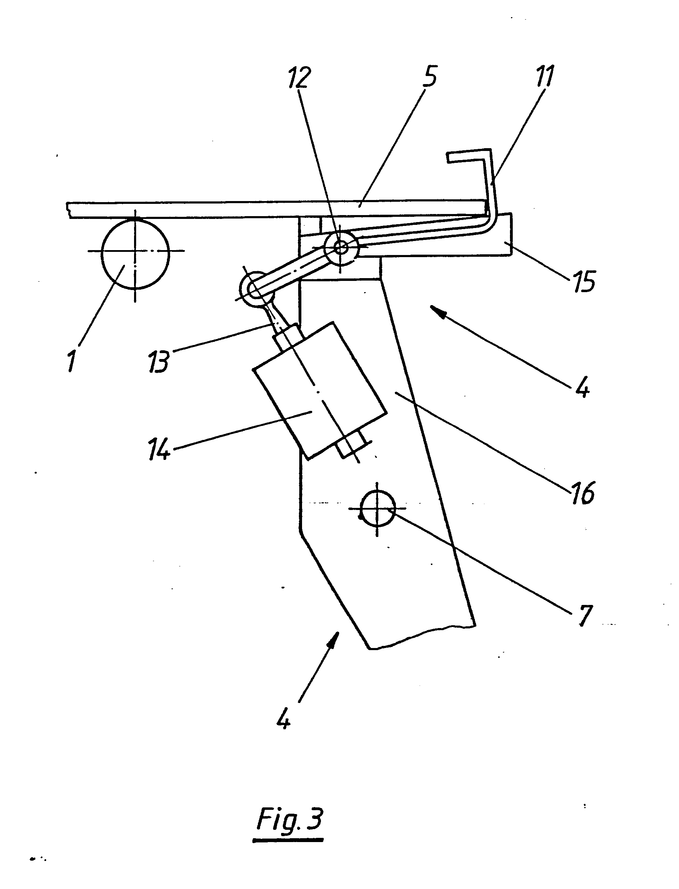

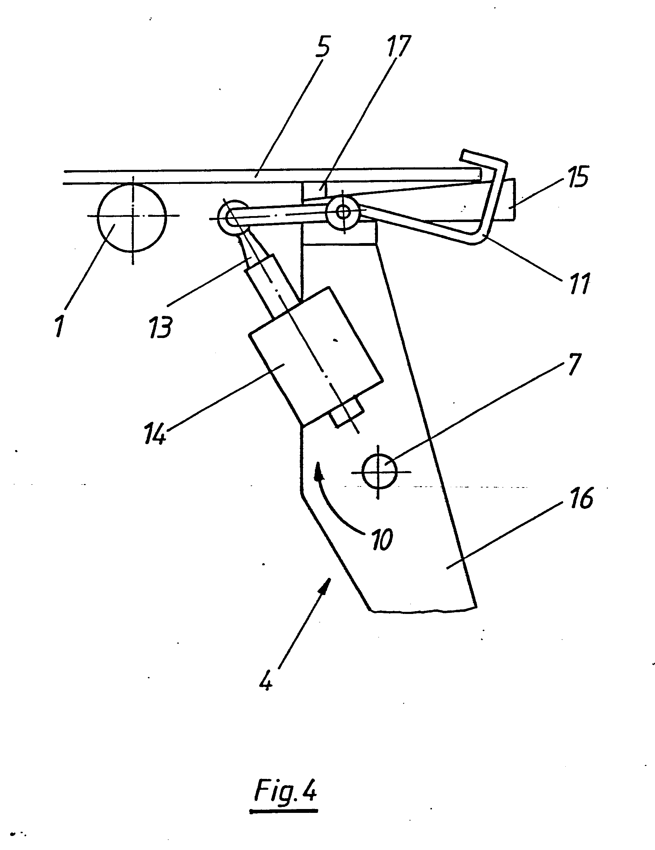

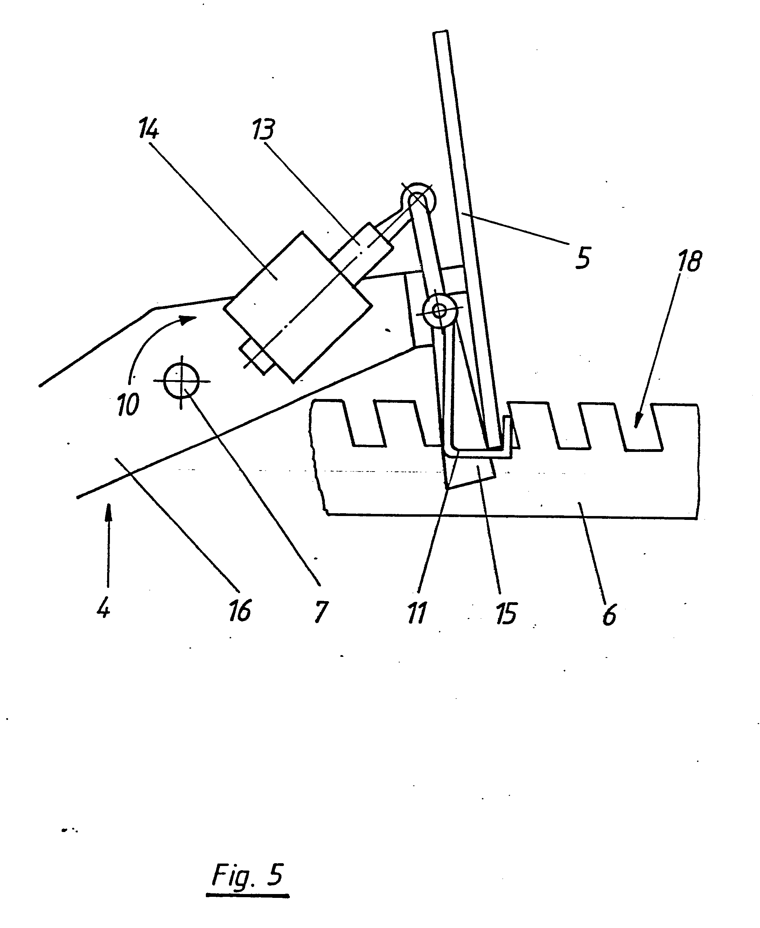

In Fig. 3 ist ein Ausschnitt des Greifers 4 in der Seitenansicht gezeigt, wobei die Leiterplatte 5 bei geöffneten beweglichen Klemmbacken 11 einläuft. Die Betätigung der Klemmbacken 11 erfolgt über die Drehachse 12 mit der Kolbenstange13, die in dem Zylinder 14 verfährt. Die festen Klemmbacken 15 sind direkt auf dem Schwenkarm 16 des Greifers 4 befestigt. Nach Fig. 4 ist ersichtlich, wie die Leiterplatte 5 zwischen den beweglichen und festen Klemmbachen (11, 15) eingespannt wird, nachdem die Kolbenstange 13 aus dem Zylinder 14 ausgefahren wurde und die Leiterplatte dabei an der Leiste 17 abgestützt wird. Aus Fig. 5 ist ferner zu ersehen, wie die Leiterplatte 5 nach dem Schwenken des Greifers um ca. 80° in einem Schlitz 18 der geschlitzten Leisten 6 eingesetzt wird. Der Schwenkarm 16 schwenkt anschließend noch um eine geringere Wegstrecke weiter, wobei die Leiterplatte 5 aus dem Greifer herausgeschoben wird. Das Weiterschwenken ist so bemessen, daß die beweglichen Klemmbacken 11 unter der Unterkante der Leiterplatte 5 stehen.

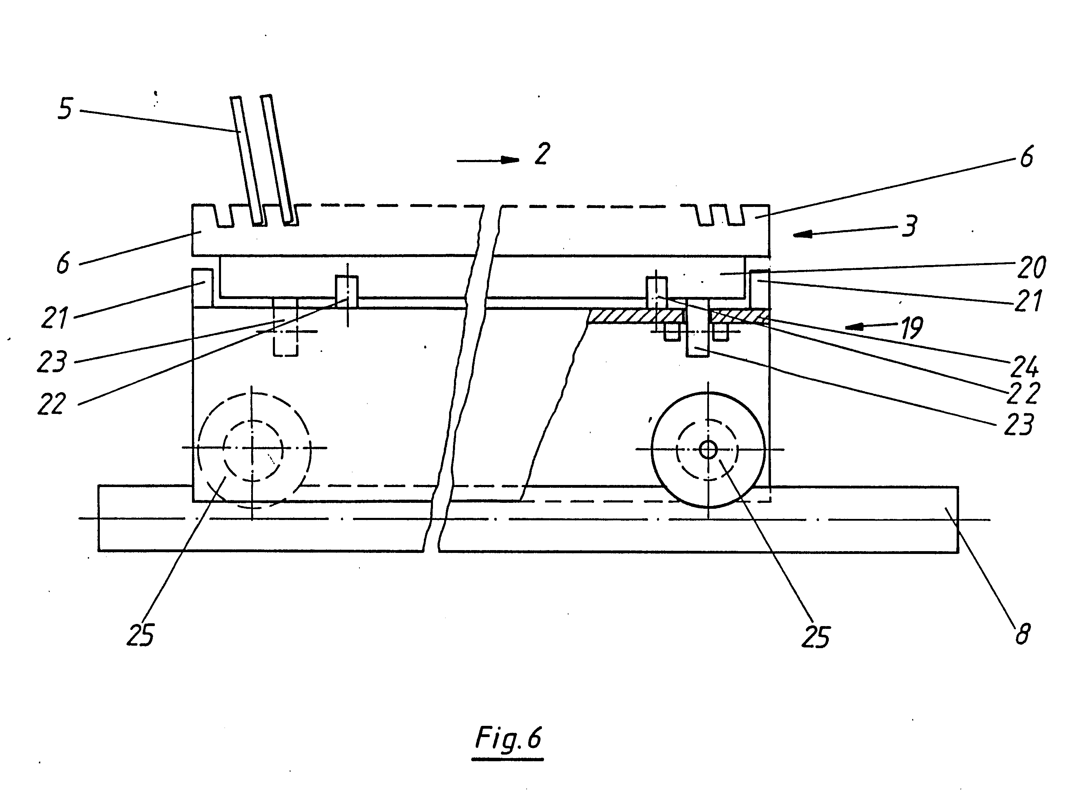

Den Palettenwagen 19 mit aufgelegter Palette 3 zeigt schließlich Fig. 6 in der Seitenansicht. Die Palette 3 ist hierbei aus der Grundplatte 20 und mehreren geschlitzten Leisten 6 aufgebaut. Sie wird auf dem Palettenwagen 19 von den Anschlägen 21 in Förderrichtung 2 und den Anschlägen 22 quer zur Förderrichtung fixiert. Statt der festen Anschläge 22 können auch bewegliche Anschläge oder eine Klinge angebracht werden, um die Palette auf dem Palettenwagen quer zur Förderrichtung 2 zu fixieren und auch ausschieben zu können. Zum leichteren Einschieben der Palette quer zur Förderrichtung 2 sind in den Boden 24 des Palettenwagens 19 mehrere Rollen 23 montiert. Der Palettenwagen selbst ist auf 4 Spurkranz-Rollen 25 gelagert, welche auf den Längsführungen 8 aufliegen.

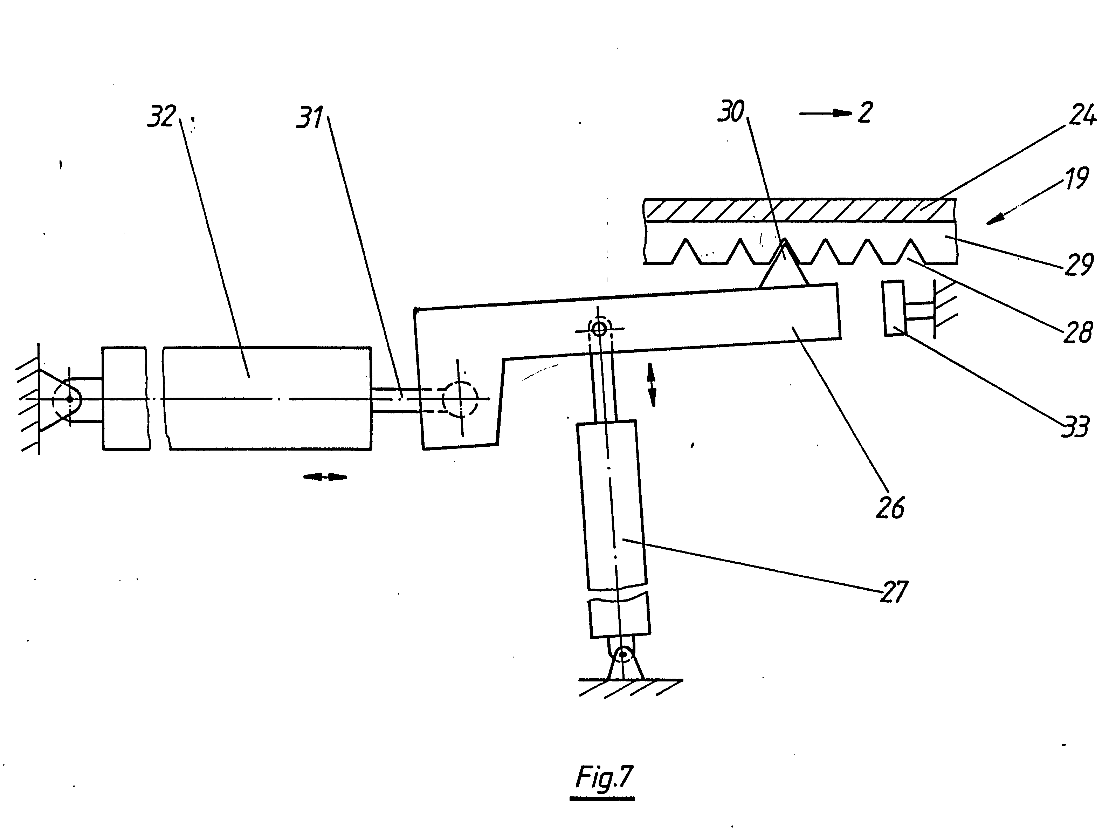

Zum taktweisen Vorschub des Palettenwagens 19 dient eine Klinke 26, wie in Fig. 7 gezeigt ist. Die Klinke wird von einem Zylinder 27 nach oben gedrückt und rastet mit der Nase 30 in die Aussparungen 28 des Mitnehmers 29 ein, der unter dem Boden 24 des Palettenwagens 19 angebracht ist. Anschließend wird die Kolbenstange 31 des Zylinders 32 in Förderrichtung 2 ausgefahren, bis die Klinke 26 gegen einen justierbaren Anschlag 33 fährt. Der Zylinder 32 und der Anschlag 33 sind so eingestellt, daß ein Hub des Kolbens 31 genau einer Teilung zwischen zwei Aussparungen 28 im Mitnhemer 29 entsprechen.

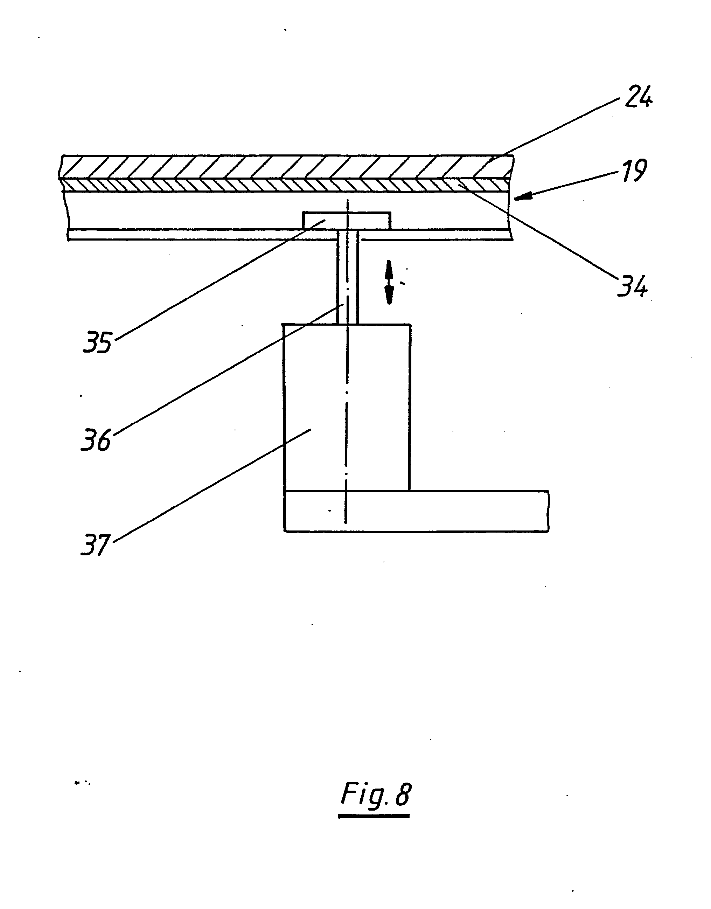

In Fig. 8 ist dargestellt, wie der Palettenwagen 19 nach dem Takten in seiner Position festgeklemmt wird. Unter dem Boden 24 des Palettenwagens ist eine C-förmige Klemmschiene 34 befestigt, in die die Klemmscheibe 35 eingreift. Diese wird über die Kolbenstange 36 von Zylinder 37 innen gegen die C-Schiene 34 gedrückt und klemmt damit den Palettenwagen 19 fest.

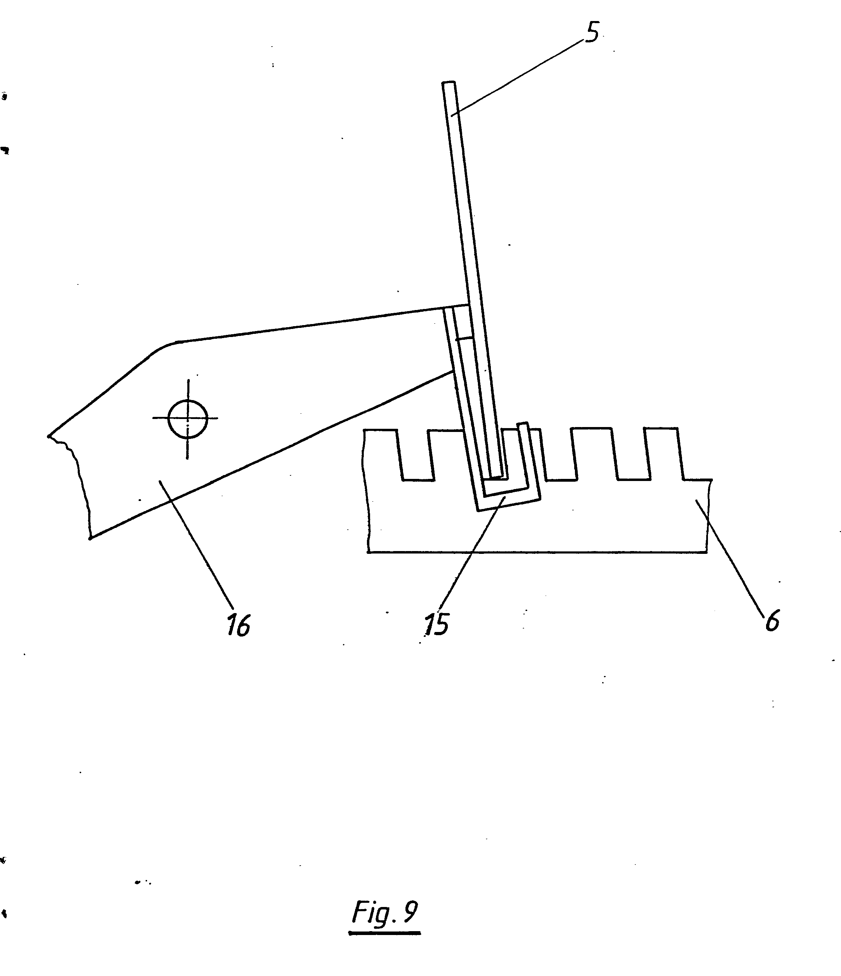

Sollen Leiterplatten umgekehrt, wie bisher geschildert, aus einer vollen Palette entnommen und einer Weiterverarbeitungsmaschine zugeführt werden, so kann mit denselben Elementen der Vorgang rückwärts ablaufen. Wird nur das Eingeben der Leiterplatten von der Palette in eine Maschine verlangt, kann der feste Klemmbacken 15, wie in Fig. 9 gezeigt, ausgeführt werden und der bewegliche Klemmbacken nach Fig. 3 entfallen.

## Ansprüche

1. Vorrichtung zum Ein- und Ausgeben von Leiterplatten in geschlitzte Wechselpaletten, in welchen die Leiterplatten berührungsfrei und in aufrechter Lage speicherbar sind,
dadurch gekennzeichnet, daß die einzelnen Leiterplatin waagrechter Lage auf Rollenbahnen in - schwenkbar angeordnete Greifer einlaufen, hierbei vorzugsweise am vorderen Plattenrand klemm- und näherungsweise in die Senkrechte über entsprechende Schlitze an einer unterhalb des Greifers positionierten Wechselpaeltte bringbar sind, wonach die Greifer beim Weiterführen vom aufgestellten Palettenrand ausschwenk- und rückbringbar sind.

2. Vorrichtung nach Anspruch 1,
dadurch gekennzeichnet, daß die Greifer aus mehreren im Abstand nebeneinander angeordneten Klemmbacken bestehen und diese zwischen die in eingeschlitzte Leisten aufgeteilte Wechselpaletten zum Aufstellen der Leiterplatten und Ausschwenken von denselben abschwenkbar sind.

3. Vorrichtung nach Anspruch 2,
dadurch gekennzeichnet, daß der untere und nach dem Aufstellen der Leiterplatten hintere Klemmbacken als Anlage fest und der die Leiterplatte vorne umgreifende und nach dem Aufstellen der Leiterplatte untere Klemmbacken als Halter beweglich gegen den ersteren bringbar ist.

4. Vorrichtung nach Anspruch 3,
dadurch gekennzeichnet, daß der bewegliche Klemmbacken als Halter neben dem festen als Anlage dienenden Klemmbacken in Form den Leiterplattenrand umgreifenden Hakenarm mittels Hydraulikkolben am Greiferarm in Klemmstellung - schwenk- und wieder öffenbar ist.

5. Vorrichtung nach einem der Ansprüche 1 bis 4,
dadurch gekennzeichnet, daß die Wechselpalette in form von eingeschlitzten Leisten mit Grundplatte auf einem Palettentisch querverfahr-und der letztere längsverfahrbar ist, wobei eine Klinkenschaltung dem Weitertakten im Schlitzabstand des Tisches dient.

6. Vorrichtung nach Anspruch 5,
dadurch gekennziechnet, daß die Schaltklinken mit einer Rastleiste oder Rollenkette am Palettentisch zusammenwirkt, wobei die Rastklinke von einem Hydraulikkolben in Längsrichtung taktbar und von einem weiteren Hydraulikkolben quer hierbei in die Rastleiste oder Rollenkette einbringbar ist.

7. Vorrichtung nach Anspruch 5 oder 6,
dadurch gekennziechnet, daß der Palettentisch parallel zur Rastleiste oder Rollenkette eine Klemmschiene vorzugsweise in Form einer C-Schiene aufweist, in welche eine Klemmscheibe als Klemmvorrichtung eingreift, die mittels Hydraulikzylinder spann- und zum Weitertakten lösbar ist.

8. Vorrichtung nach einem der vorhergehenden Ansprüche,
dadurch gekennzeichnet, daß die Wechselpalette quer zur Förderrichtung des fahrbaren Palettentischs auf Rollen aus- und einbringbar ist und mittels einerseits festen und andererseits rastbaren Anschlägen zu halten ist.

9. Vorrichtung nach Anspruch 1,
dadurch gekennzeichnet, daß bei Verwendung der Vorrichtung zum Eingeben der Leiterplatten von der Palette in eine Weiterverarbeitungsmaschine der Greifer in Form von starren Anlage- und Haltebacken als Mitnehmer zum Rpckkippen aufgestellter Leiterplatten - anstelle von festen und beweglichen Klemmbacken - ausgerüstet ist.

_Fig.1_

0 292 807

Fig. 2

Fig. 3

Fig. 4

0 292 807

*Fig. 5*

*Fig.6*

0 292 807

Fig.7

Fig. 8

_Fig. 9_